# EUROPEAN PATENT SPECIFICATION

(11) **EP 4 446 685 B1**
(45) Date of publication and mention of the grant of the patent: **25.02.2026**
(21) Application number: 24198232.1
(22) Date of filing: 21.06.2021
(51) Int. Cl.: F28D 15/02, F28F 3/02

(54) **HEAT EXCHANGER AND MANUFACTURING METHOD OF THE SAME**
WÄRMETAUSCHER UND HERSTELLUNGSVERFAHREN DAFÜR
ÉCHANGEUR DE CHALEUR ET SON PROCÉDÉ DE FABRICATION

(30) Priority: 01.07.2020 US 202063046721 P
(43) Date of publication of application: 16.10.2024
(62) Divisional of application: 21180515.5
(73) Proprietor: Cooler Master Co., Ltd., Taipei City 114065 (TW)
(72) Inventor: Lin, Chia-Yu, 114065 Taipei City (TW); Cheng, Shan-yin, 114065 Taipei City (TW)
(74) Representative: Grünecker Patent- und Rechtsanwälte PartG mbB

(56) References cited:
- DE-U1- 212013 000 272
- US-A1- 2013 264 043
- US-A1- 2017 363 366
- US-A1- 2018 283 797
- US-A1- 2018 308 780

## Description

### TECHNICAL FIELD

Example embodiments relate generally to the field of heat transfer and, more particularly, to heat exchanger fins and manufacturing methods of the same.

### BACKGROUND

During operation of electric and electronic elements, devices and systems, the heat generated thereby must be dissipated quickly and efficiently to keep operating temperature within manufacturer recommended ranges, under, at times, challenging operating conditions. As these elements, devices and systems increase in functionality and applicability, so does the power requirements thereof, this in turn increases cooling requirements.

Several techniques have been developed for extracting heat from electric and electronic elements, devices and systems. One such technique is an air-cooling system, wherein a heat exchanger is in thermal contact with the elements, devices or systems, transporting heat away therefrom, and then air flowing over the heat exchanger removes heat from the heat exchanger. One type of heat exchanger consists of a plurality of fins extending from a base plate. The plurality of fins increases the rate of convective heat transfer to or from an environment of the heat exchanger, by increasing the surface area of a heat source in thermal contact with the heat exchanger. Heat is transferred from the heat source to the base plate, the base plate to the plurality of fins and the environment, and the plurality of fins to the environment.

Convective heat transfer may be aided by a fan, blower, or any other source, or natural convection may be employed. For natural convection, higher temperature air is less dense than its surrounding air and rises out of the heat exchanger and plurality of fins naturally, opposite the direction of gravity. For natural convection, the attached positioning of the heat exchanger and orientation of the plurality of fins during operation is in a direction that will not block air movement. During operation, when positioned horizontally, the plurality of fins face upward, and when positioned vertically, the plurality of fins is oriented to allow higher temperature air to conveniently rise.

The thermal performance of the plurality of fins of the heat exchangers is dependent on heat transfer effectiveness. Thus, shape, thickness, material, and enhancements all contribute to the thermal performance of the plurality of fins. One heat exchanger fin shape is a rectangular fin shape. The size of the rectangular fin shape is regulated to the square area allotted for the heat exchanger applied to the electric and/or electronic elements, devices and systems. Thus, further increasing the rate of convective heat transfer to or from an environment of the heat exchanger, by increasing the surface area of a heat source in thermal contact with the heat exchanger via the plurality of fins is a challenge.

DE 21 2013 000 272 U1, on which the preamble of claim 1 is based, shows a phase change heat transfer device, especially in form of a heat wing. The heat wing includes two plates and a frame connecting the two plates. The two plates and the frame constitute a plate-shaped hollow chamber. A capillary structure layer is closely attached to an inner surface of the chamber. A phase transition working medium is hermetically sealed in the chamber. A portion of the frame, such as a portion of the bottom frame section, comes in contact with a heat source, and thus functions as an evaporation area, while the rest portion of the chamber acts as a condensation area. The length and the width of the heat wing are several times larger than the thickness so that a vapor transmission channel of the heat wing is relatively large. A thermally driven flow of the working medium is created within the heat wing.

US 2013/264043 A1 describes a heat sink radiation fin and base block mounting structure comprising a base block and a plurality of radiation fins. The base block provides a plurality of grooves at the top wall thereof for the insertion of the radiation fins respectively. Further, each radiation fin has its bottom edge stamped to provide a plurality of folded portions that are equally spaced along the bottom edge of the radiation fin and alternatively projecting in two opposite directions. By means of the folded portions, the radiation fins can be steadily positioned in the respective grooves of the base block, and then integrally embedded in or clamped to the base block by means of casting or squeezing technique.

US 2018/308780 A1 refers to a thermally superconducting radiator comprising a plurality of separators and a plurality of thermally superconducting heat dissipation fins. The separators and the thermally superconducting heat dissipation fins are alternately arranged, and one end face of the separators is flush with one end face of the thermally superconducting heat dissipation fin, so that they together form a mounting surface suitable for mounting a power device. The thermally superconducting heat dissipation fin comprises two plates, which are compounded together by a rolling process. Closed pipes that are interconnected and have a certain structure and shape are formed between the two plates by an inflation process. Convex structures corresponding to the closed pipes are formed on the surfaces of the two plates. The closed pipes are filled with a heat transfer working medium. Separators are provided with grooves. The grooves are shaped to match the shape of the convex structure of the closed pipes located between the separators. As a result, the separators and the thermally conducting heat dissipation fins can be closely fitted and alternatingly arranged. Gaps remain between the remainder of the dissipation fins.

### BRIEF SUMMARY

The invention solves the above mentioned problems through a heat exchanger according to claim 1. Preferred embodiments are specified in the dependent claims.

Disclosed herein is also a heat exchanger fin comprising a channel system, the channel system is at least divided into a first part included in a first portion of the heat exchanger fin and a second part included in a second portion of the heat exchanger fin, wherein the first portion and the second portion are angled towards each other in an angle range of >0° to <180°, and wherein the channel system is under vacuum and has a working fluid therein.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of heat exchanger systems and methods incorporating aspects of the presently disclosed principles are illustrated by way of example, and not by way of limitation.
Fig. 1A is a schematic perspective second view of a heat exchanger, according to an example embodiment.
Fig. 1B is a schematic perspective first view of a heat exchanger, according to an example embodiment.
Fig. 2A is schematic perspective second view of a heat exchanger fin of the heat exchanger of Fig. 1A and Fig. 1B, according to an example embodiment.
Fig. 2B is schematic perspective first view of the heat exchanger fin of Fig. 2A, according to an example embodiment.
Fig. 2C is schematic perspective third view of the heat exchanger fin of Fig. 2A, according to an example embodiment.
Fig. 2D is schematic perspective fifth view of the heat exchanger fin of Fig. 2A, according to an example embodiment.
Fig. 3A is schematic perspective first view of an at least a first metal sheet of the heat exchanger fin of Fig. 1A and Fig. 1B, according to an example embodiment.
Fig. 3B is schematic perspective first view of an at least a second metal sheet of the heat exchanger fin of Fig. 1A and Fig. 1B, according to an example embodiment.
Fig. 4 is a flow chart illustrating a manufacturing method of the heat exchanger fin of Fig. 1A and Fig. 1B, according to an example embodiment.
Fig. 5A is schematic perspective first view of the heat exchanger fin of Fig. 1A and Fig. 1B following Step 440 of the manufacturing method of Fig. 4, according to an example embodiment.
Fig. 5B is schematic perspective first view of the heat exchanger fin of Fig. 5A following Step 460 of the manufacturing method of Fig. 4, according to an example embodiment.
Fig. 6 is schematic perspective first view of an alternative heat exchanger, according to an example embodiment.

### DETAILED DESCRIPTION

The following describes various principles related to heat exchanger systems and methods by way of reference to specific examples of heat exchanger systems and methods, including specific arrangements and examples of metal sheets and channels embodying innovative concepts. More particularly, but not exclusively, such innovative principles are described in relation to selected examples of heat exchanger systems and methods and well-known functions or constructions are not described in detail for purposes of succinctness and clarity. Nonetheless, one or more of the disclosed principles can be incorporated in various other embodiments of heat exchanger systems and methods to achieve any of a variety of desired outcomes, characteristics, and/or performance criteria.

Thus, heat exchanger systems and methods having attributes that are different from those specific examples discussed herein can embody one or more of the innovative principles, and can be used in applications not described herein in detail. Accordingly, embodiments of heat exchanger systems and methods not described herein in detail also fall within the scope of this disclosure, as will be appreciated by those of ordinary skill in the relevant art following a review of this disclosure.

Example embodiments as disclosed herein are directed to heat exchangers and heat exchanger fins, under vacuum, and having a working fluid therein, and manufacturing methods of the heat exchanger fins. In an embodiment, a heat exchanger comprising a plurality of heat exchanger fins and a base plate is provided. Each heat exchanger fin comprises a first portion (an exchanger enhancement) and a second portion (auxiliary enhancement) having channels therein. The channels are formed by at least a first and second metal sheet. The channels are under vacuum and have a working fluid therein. The closed-loop system of channels of each of the plurality of fins increases the rate of convective heat transfer to or from an environment of the heat exchanger by evaporation of a working fluid, which is spread by a vapor flow filling the vacuum. The vapor flow eventually condenses over cooler surfaces, and, as a result, the heat is distributed from a heat source evaporation interface surface to a larger condensation cooling surface area. An at least a second portion of the feat exchanger fin increases the surface area of the heat source in thermal contact with the heat exchanger via the plurality of fins, thus, further increasing the rate of convective heat transfer to or from an environment of the heat exchanger while not increasing the square area allotted for the heat exchanger applied to an electric and/or electronic elements, devices and systems.

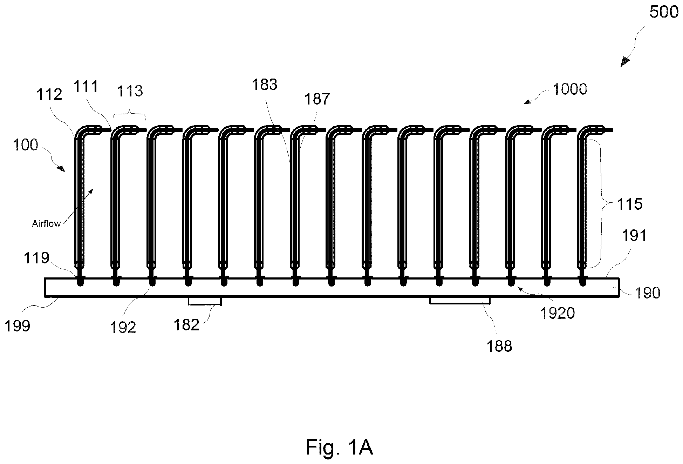

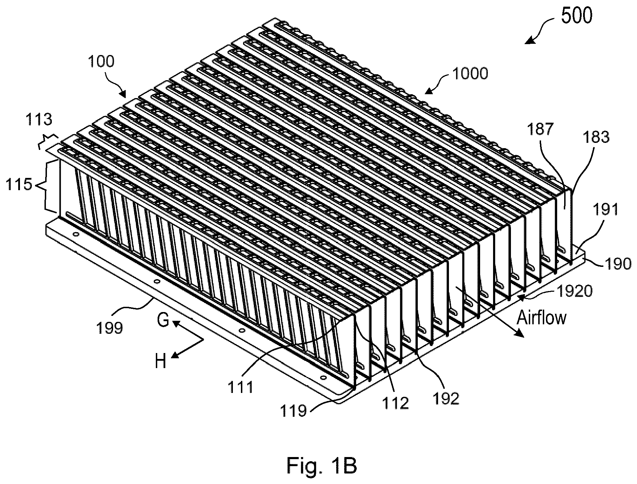

Fig. 1A is a schematic perspective second view of a heat exchanger, according to an example embodiment. Fig. 1B is a schematic perspective first view of a heat exchanger, according to an example embodiment. The heat exchanger 500 may be employed to cool at least one of an electric and/or electronic element, device and/or system. Referring to Figs. 1A and 1B, the heat exchanger 500 comprises a plurality of heat exchanger fins 1000 and a base plate 190. Each heat exchanger fin 100 of the plurality of heat exchanger fins 1000 comprises a fin base 119, a fin intermediary 112, opposite the fin base 119, and a fin tip 111, and a first portion 115 and a second portion 113. The base plate 190 comprises a mounting surface 191 and a contact surface 199, opposite the mounting surface 191. The mounting surface 191 has a plurality of mounting grooves 1920 thereon, substantially parallel thereamong and evenly spaced apart.

The dimensions, depth, and amount of each mounting groove 192 of the plurality of mounting grooves 1920 correspond to the dimensions, height and amount of each fin base 119 of each heat exchanger fin 100. Each fin base 119 of each heat exchanger fin 100 may be thermally and mechanically, permanently attached to each mounting groove 192 by brazing techniques known to those of ordinary skill in the relevant art; however, the embodiments are not limited thereto. Other appropriate methods may be employed, as long as heat may be efficiently and effectively transferred from the base plate 190 to the plurality of heat exchanger fins 1000. In some embodiments, each fin base 119 may be hemmed, reinforcing the strength thereof and increasing the surface area for conductive heat transfer from the base plate 190 to the plurality of heat exchanger fins 1000.

The area occupied by the plurality of heat exchanger fins 1000 on the mounting surface 191 may be varied depending upon application and design requirements. As an example, the area may be smaller, resulting in a non-occupied area of the mounting surface 191 on one or more than one side thereof, or the area may be larger, extending outward over one or more side edges of the mounting surface 191, and the embodiments are not limited thereto.

One or more heat sources of electric and/or electronic elements, devices and/or systems, and/or any combination thereof, may be attached to the contact surface 199, for example and not to be limiting, by fastening or other means known to those of ordinary skill in the relevant art. As long as heat may be efficiently and effectively transferred from the one or more heat sources to the base plate 190.

In some embodiments, a first heat source 182 and a second heat source 188 is attached to the contact surface 199 of the base plate 190. The power requirement and maximum operating temperature allowance of the first heat source 182 may be less than that of the second heat source 188 and when in operation, the first heat source 182 is closer to ground (G) than that of the second heat source 188 (i.e. a main axis M₁ of the first portion 115 and a main axis M₂ of the second portion 113 are oriented substantially vertical, namely in a range ± 15°, preferably in a range ± 7.5° to vertical, when the heat exchanger fin (100; 600) is in use); however, the embodiments are not limited thereto. There may be more than one heat source having different power requirements and maximum operating temperature allowances.

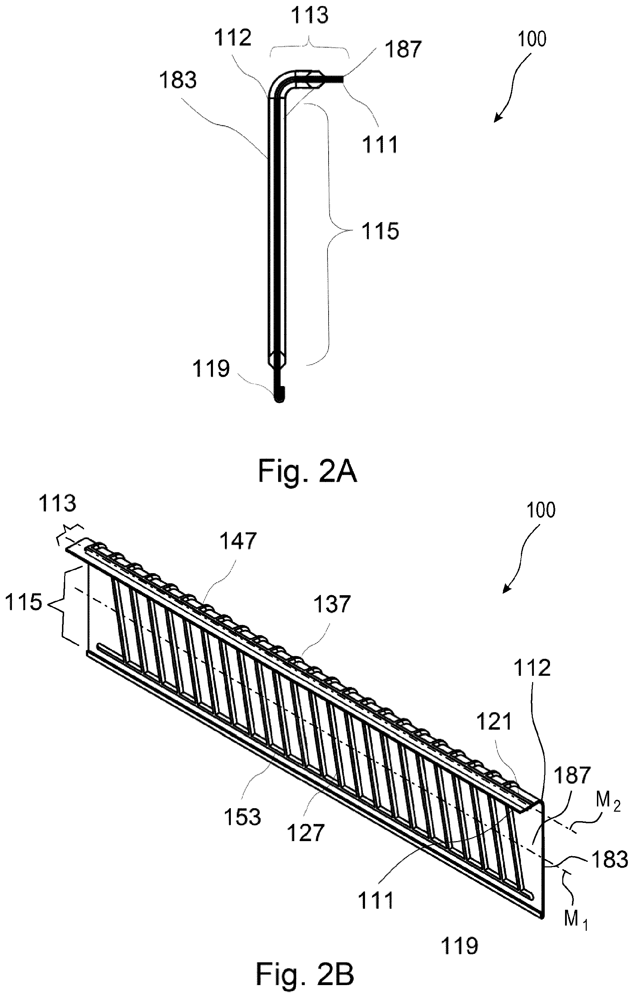

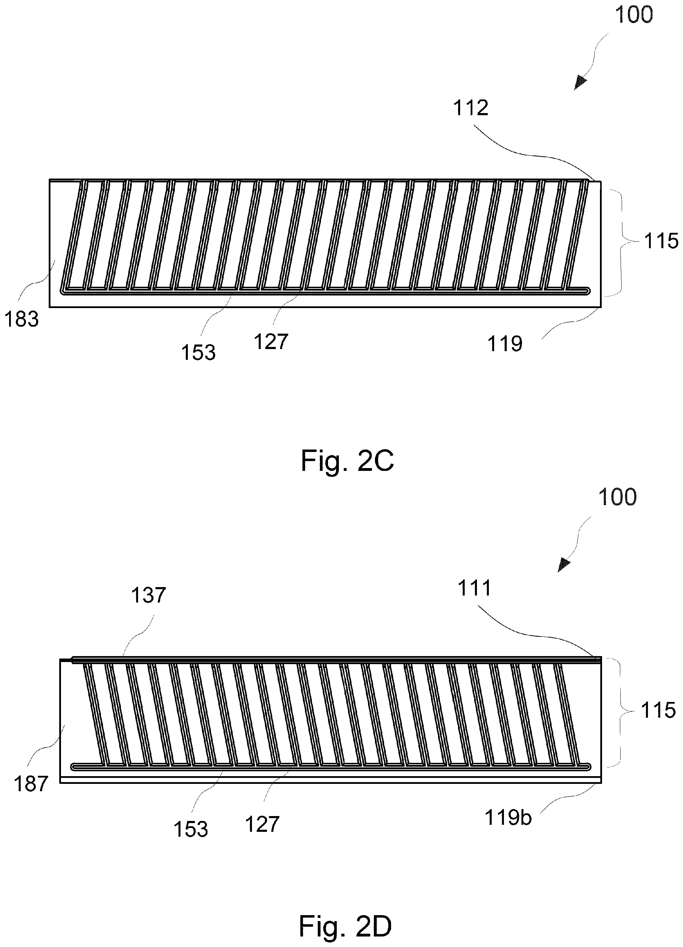

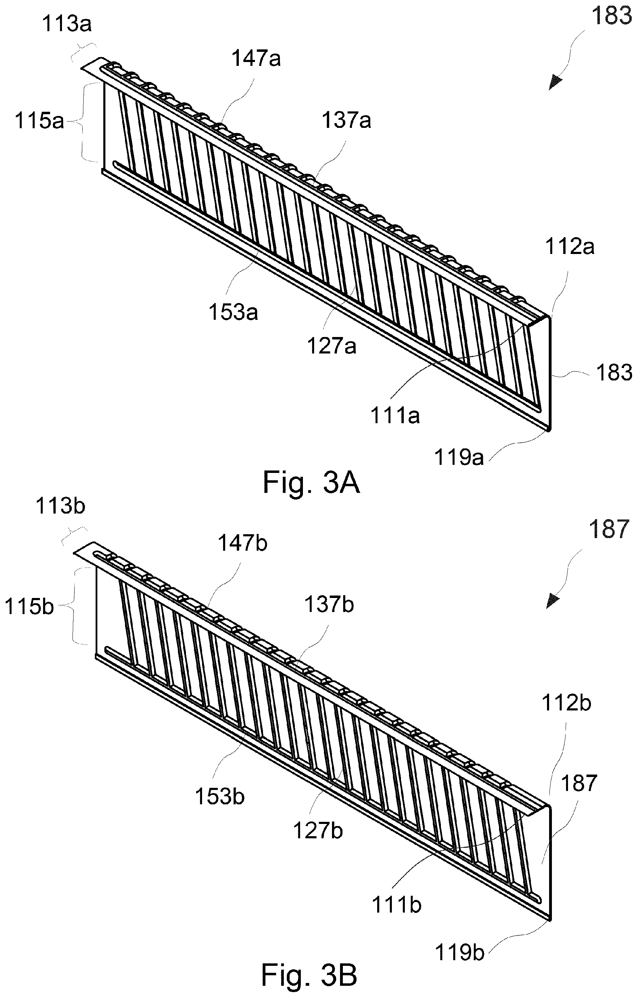

Fig. 2A is schematic perspective second view of a heat exchanger fin of the heat exchanger of Fig. 1A and Fig. 1B, according to an example embodiment. Fig. 2B is schematic perspective first view of the heat exchanger fin of Fig. 2A, according to an example embodiment. Fig. 2C is schematic perspective third view of the heat exchanger fin of Fig. 2A, according to an example embodiment. Fig. 2D is schematic perspective fifth view of the heat exchanger fin of Fig. 2A, according to an example embodiment. Fig. 3A is schematic perspective first view of an at least a first metal sheet of the heat exchanger fin of Fig. 1A and Fig. 1B, according to an example embodiment. Fig. 3B is schematic perspective first view of an at least a second metal sheet of the heat exchanger fin of Fig. 1A and Fig. 1B, according to an example embodiment. Referring to Figs. 2A to 3B, and referring to Figs. 1A and 1B, each of the heat exchanger fins 100 further comprise at least a first metal sheet 183 and at least a second metal sheet 187 having a first inner surface assembled to a second inner surface. The first and second metal sheet 183, 187, form the fin base 119, the fin intermediary 112 opposite the fin base 119 and the fin tip 111 and the second portion 113 comprising the at least a condensation channel 137 and auxiliary channel 147a, 147b, and the first portion 115 comprising the at least a connecting channel 127a, 127b and at least an evaporation channel 153.

In some embodiments, the at least a second portion 113 has at least a condensation channel 137 along and near to an outer perimeter length thereof, or the fin tip 111, and at least an auxiliary channel 147a, 147b, communicating therewith. The first portion 115 has at least an evaporation channel 153 along and near to an outer perimeter length thereof, or the fin base 119, and at least a connecting channel 127a, 127b, communicating therewith. The at least an auxiliary channel 147a, 147b communicates with the at least a connecting channel 127a, 127b, respectively. The at least a condensation channel 137 communicates with the at least an auxiliary channel 147a, 147b communicating with the at least a connecting channel 127a, 127b, respectively, and the at least an evaporation channel 153 communicates with the at least a connecting channel 127a, 127b, respectively. The at least an auxiliary channel 147a, 147b and at least a connecting channel 127a, 127b are evenly disposed parallel and at a slight angle to the at least an evaporation channel 153 and at least a condensation channel 137. The degree of the angle in the embodiments is not limited. As long as downward working fluid flow may be generated.

In some embodiments, the amount of the at least a condensation channel 137 and at least an evaporation channel 153 is one, respectively; however, the embodiments are not limited thereto. In alternative embodiments, there may be more than one condensation channel and more than one evaporation channel. As long as the more than one condensation channel is disposed in the at least a second portion 113, and the condensation channels and the at least an auxiliary channel 147a, 147b are in communication thereamong and as long as the more than one evaporation channel is disposed in the first portion 115, and the evaporation channels and the at least a connecting channel 127a, 127b are in communication thereamong and the at least a connecting channel 127a, 127b is in communication with the at least an auxiliary channel 147a, 147b, respectively.

In some embodiments, there is one at least an auxiliary channel 147a, one at least an auxiliary channel 147b, one at least a connecting channel 127a, and one at least a connecting channel 127b, respectively; however, the embodiments are not limited thereto. In alternative embodiments, there may be two or more at least an auxiliary channel 147a, two or more at least an auxiliary channel 147b, two or more at least a connecting channel 127a, and/or two or more at least a connecting channel 127b, respectively, and any combination thereof. In an example, and not to be limiting, in some embodiments, the amount of the at least an auxiliary channel 147a and at least at least a connecting channel 127a is twenty-four and at least an auxiliary channel 147b and at least at least a connecting channel 127b is twenty-three. As long as the two or more at least an auxiliary channel 147a and/or two or more at least an auxiliary channel 147b are disposed in the at least a second portion 113, respectively, two or more at least a connecting channel 127a and/or two or more at least a connecting channel 127b are disposed in the first portion 115, respectively, and the two more at least an auxiliary channel 147a, two or more at least an auxiliary channel 147b, two or more at least a connecting channel 127a, and/or two or more at least a connecting channel 127b are evenly disposed parallel thereamong and at a slight angle to the at least an evaporation channel 153 and at least a condensation channel 137, respectively.

In some embodiments, the flow volume of the at least a condensation channel 137 and the at least an evaporation channel 153 is generally even thereacross and twice as large as the at least one auxiliary channel 147a, 147b, at least one connecting channel 127a, 127b, respectively; however, the embodiments are not limited thereto. Those of ordinary skill in the relevant art may readily appreciate that the vertical and horizontal dimensions may be varied, respectively, depending upon application and design requirements. As long as the at least one condensation channel 137, at least one auxiliary channel 147a, 147b, at least one connecting channel 127a, 127b, and at least one evaporation channel 153 increases the heat dissipation and thermal performance of each of the plurality of heat exchanger fins 1000 and when operating vertically, the at least a second portion 113 increases the surface area of a heat source in thermal contact with the heat exchanger 500 while not increasing the square area allotted for the heat exchanger 500 and preventing insulating blanket layers around heat source walls from forming and restricting heat transfer.

In some embodiments, each of the plurality of heat exchanger fins 1000, is under vacuum, and has a working fluid therein. The working fluid is distributed naturally in the form of liquid vapor slugs/bubbles throughout the at least one auxiliary channel 147a, 147b of the second portion 113 and at least one connecting channel 127a, 127b and at least an evaporation channel 153 of the first portion 115. Each heat exchanger fin 100 comprises an evaporator region (at least an evaporation channel 153), a condenser region (at least one condensation channel 137), vapor flow region (at least one auxiliary channel 147a, 147b and at least one connecting channel 127a, 127b) extending from the evaporator and condenser regions, respectively. When heat from the at least a first heat source 182 and at least a second heat source 188 is applied to the contact surface 199 of the base plate 190, the heat converts the working fluid to vapor and the vapor bubbles become larger within the vapor flow region. Meanwhile, at the condenser region, heat is being removed and the bubbles are reducing in size. The volume expansion due to vaporization and the contraction due to condensation causes an oscillating motion within the channels (the at least one condensation channel 137, at least one auxiliary channel 147a, 147b, at least one connecting channel 127a, 127b, and at least an evaporation channel 153). The volume of the condenser region is at least equal to or greater than the volume of the evaporator region, facilitating the oscillating motion. The net effect of the temperature gradient between the evaporator region and condenser region and the tensions introduced throughout the at least one condensation channel 137, at least one auxiliary channel 147a, 147b, at least one connecting channel 127a, 127b, and at least an evaporation channel 153, creates a non-equilibrium pressure condition. The increased output pressure gain in downward working fluid flow through the at least one auxiliary channel 147a, 147b, a portion of the at least one connecting channel 127a, 127b, boosts upward oscillation driving forces throughout the at least an evaporation channel 153 and an other portion of the at least one connecting channel 127a, 127b, and increased surface area of the second portion 113a, 113b, improving the heat transfer efficiency rate for electric and/or electronic elements, devices and systems. Thermo-fluidic transport is provided within each heat exchanger fin 100 via the self-sustaining oscillation driving forces, whereby the pressure pulsations are fully thermally driven.

Those of ordinary skill in the relevant art may readily appreciate that the shape, width and lengths of the at least one condensation channel 137 and at least one auxiliary channel 147a, 147b of the second portion 113 and at least one connecting channel 127a, 127b and at least an evaporation channel 153 of the first portion 115 may be varied, such as having a wavy shape, having larger or smaller widths and having longer or shorter lengths, respectively, and/or any combination thereof, depending upon application and design requirements and the embodiments are not limited thereto. As long as the at least one condensation channel 137, at least one auxiliary channel 147a, 147b, at least one connecting channel 127a, 127b, and at least an evaporation channel 153 increases the heat dissipation and thermal performance of each of the plurality of heat exchanger fins 1000 and when operating vertically, the at least a second portion 113 increases the surface area of a heat source in thermal contact with the heat exchanger 500 while not increasing the square area allotted for the heat exchanger 500 while preventing insulating blanket layers around heat source walls from forming and restricting heat transfer.

The plurality of heat exchanger fins 1000, under vacuum, having a working fluid in the at least a condensation channel 137, at least an auxiliary channel 147a, 147b, at least a connecting channel 127a, 127b, and at least an evaporation channel 153, increases the heat dissipation and thermal performance of each of the plurality of heat exchanger fins 1000 when compared to solid heat exchanger fins. Also, for electric and/or electronic elements, devices and systems that operate vertically, the at least a second portion 113a, 113b increases the surface area of the heat source in thermal contact with the heat exchanger while not increasing the square area allotted for the heat exchanger. Thus, the rate of convective heat transfer is even further increased while preventing insulating blanket layers around heat source walls from forming and restricting heat transfer.

In some embodiments, the first and second inner surfaces of the first and second metal sheets 183, 187, respectively, are bonded together and integrally formed at areas other than the at least one condensation channel 137 and at least one auxiliary channel 147a, 147b of the second portion 113 and at least one connecting channel 127a, 127b and at least one evaporation channel 153 of the first portion 115; however the embodiments are not limited thereto.

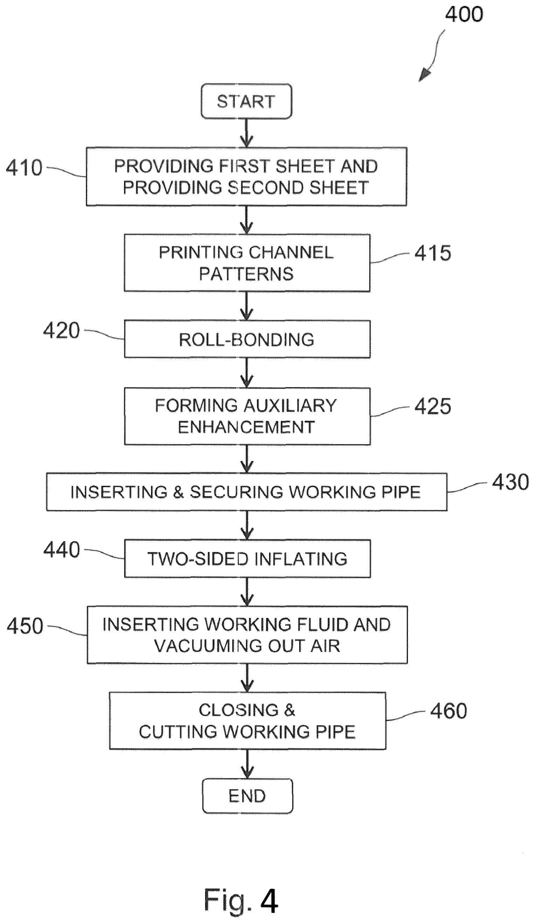

In some embodiments, each heat exchanger fin 100 is made of aluminum, or an aluminum-alloy or the like, and formed by roll-bonding. Fig. 4 is a flow chart illustrating a manufacturing method 400 of the heat exchanger fin 100 of Fig. 2A, according to an example embodiment. Referring to Fig. 4, and referring to Figs. 1A to 3B, the method 400 of manufacturing each heat exchanger fin 100, under vacuum, having a working fluid therein, generally comprises a providing Step 410, a pattern printing Step 415, a roll-bonding Step 420, a forming Step 425, an inflating Step 440, an inserting and vacuuming Step 450 and a closing and cutting Step 460. The first step, Step 410, comprises providing at least a first metal sheet 183 and at least a second metal sheet 187. In some embodiments, the at least a first and second metal sheets 183, 187 are metal coils, unrolled through an unwinder and then aligned by a suitable roller stand. Next, in Step 415, a pattern of at least a condensation channel 137, at least an auxiliary channel 147a, 147b, at least a connecting channel 127a, 127b, and at least an evaporation channel 153 are printed on the at least a first metal sheet 183. In some embodiments, the sheets are cleaned and then printed by a screen printing process employing a graphite pattern of at least a condensation channel 137, at least an auxiliary channel 147a, 147b, at least a connecting channel 127a, 127b, and at least an evaporation channel 153. In some embodiments, each heat exchanger fin 100 further comprises a working channel, extending from one end of the working section 521 to an outer edge of each heat exchanger fin 100. In some embodiments, the screen printing process employing the graphite pattern also prints the working channel. Following, in Step 420, the first inner surface of the at least first metal sheet and second inner surface of the at least second metal sheet are integrally bonded in areas other than the channel printed areas. Thereafter, in Step 425, the second portion 113 is formed by bending. In some embodiments, the bent width of the second portion 113 is generally determined and equal to the distance between each plurality of heat exchanger fins 1000; however, the embodiments are not limited thereto. The bent width may be shorter than the distance between each plurality of heat exchanger fins 1000. As long as the second portion 113 comprises the at least a condensation channel 137 and at least an auxiliary channel 147a, 147b and the channels communicate with the at least a connecting channel 127a, 127b and at least an evaporation channel 153 of the first portion 115.

Those of ordinary skill in the relevant art may readily appreciate that the use of graphite serves as a release agent, thus, preventing the at least first and second metal sheets from integrally bonding in at least the areas of the applied patterned; however, the embodiments are not limited thereto. Any type of method or material may be employed as known and common for those skilled in the relevant art to serve as the release agent. As long as the at least first and second metal sheets are prevented from integrally bonding in the at least areas of the applied following the roll-bonding step.

In some embodiments, the thickness of the at least a first and second metal sheets is between around 0.250 mm and 3.00 mm, having a reduction of each of the at least a first and second metal sheets of between around 40% to 60%; however, the embodiments are not limited thereto. Those of ordinary skill in the relevant art may readily appreciate that thicknesses and reduction of each of the at least a first and second metal sheets can be more or less, depending upon the material, starting thickness, amount of sheets, processes employed, and design requirements for effective and efficient thermal performance.

In some embodiments, the shape of each heat exchanger fin 100 is quadrilateral shaped; however, the embodiments are not limited thereto. Those of skill in the relevant art may readily appreciate that each heat exchanger fin may be of a shape other than quadrilateral shaped, and may be made up of more than one shape according to application and design requirements. As long as the at least a condensation channel 137, at least an auxiliary channel 147a, 147b, at least a connecting channel 127a, 127b, and at least an evaporation channel 153 increases the heat dissipation and thermal performance of each of the plurality of heat exchanger fins 1000 and when operating vertically, the at least a second portion 113a, 113b increases the surface area of a heat source in thermal contact with the heat exchanger 500 while not increasing the square area allotted for the heat exchanger 500.

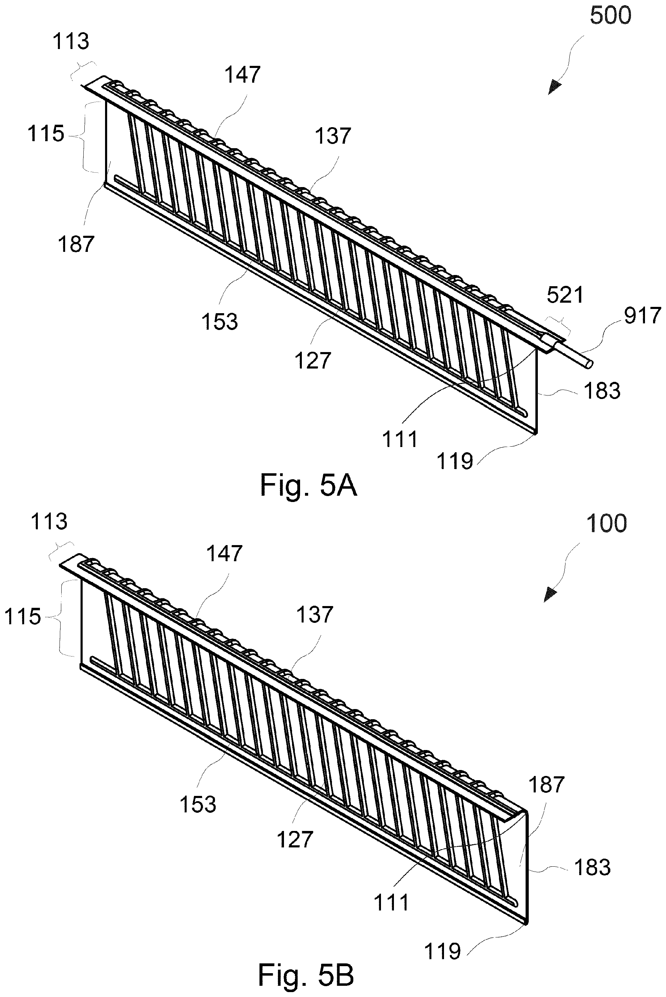

Fig. 5A is schematic perspective first view of the heat exchanger fin of Fig. 1A and Fig. 1B following Step 440 of the manufacturing method of Fig. 4, according to an example embodiment. Referring to Fig. 5A, and referring to Figs. 1A to 4, next, in Step 430 a working pipe 917 is inserted and secured to a working channel, extending from the one end of a working section 521 to an outer edge of each heat exchanger fin 100. The working pipe allows for communication with the outside atmosphere and the at least a condensation channel 137, at least an auxiliary channel 147a, 147b, at least a connecting channel 127a, 127b, and at least an evaporation channel 153. Following, in Step 440, the channels are inflated via a gas having a pressure configured for even inflation throughout each heat exchanger fin 100. In some embodiments, the gas is atmospheric air having a suitable pressure for inflation; however, the embodiments are not limited thereto. In alternative embodiments, the gas may be nitrogen, oxygen, argon, hydrogen, carbon dioxide, or any of the commonly available commercial gasses or compatible mixtures thereof. In some embodiments, the at least a first and second metal sheet 183, 187 is inserted into a mold before inflating for even inflation throughout each heat exchanger fin 100.

In some embodiments, the height or radius of the at least a condensation channel 137 and at least an evaporation channel 153 from a cross-section is between around 0.125 mm and 1.50 mm and the at least an auxiliary channel 147a, 147b and at least a connecting channel 127a, 127b from a cross-section is between around 0.0625 mm and 0.75 mm; however, the embodiments are not limited thereto. Those of ordinary skill in the relevant art may readily appreciate that the height or radius of the at least a condensation channel 137, at least an auxiliary channel 147a, 147b, at least a connecting channel 127a, 127b, and at least an evaporation channel 153 can be larger or smaller and/or varied, or any combination thereof, depending upon the material, starting thickness, amount of sheets, processes employed, and design requirements for effective and efficient thermal performance.

Next, in Step 450 a working substance is inserted into the working pipe and then air is vacuumed out. Fig. 5B is schematic perspective first view of the heat exchanger fin of Fig. 5A following Step 460 of the manufacturing method of Fig. 4, according to an example embodiment. Referring to Fig. 5B, and referring to Figs. 1A to 5A, in Step 460, the working pipe 917 is closed and sealed by flattening and then bonding thereof, and after cooling, the working channel of the working section 521 is cut, forming each heat exchanger fin 100 comprising the at least a condensation channel 137 and at least an auxiliary channel 147a, 147b of the second portion 113 and at least a connecting channel 127a, 127b and at least an evaporation channel 153 of the first portion 115.

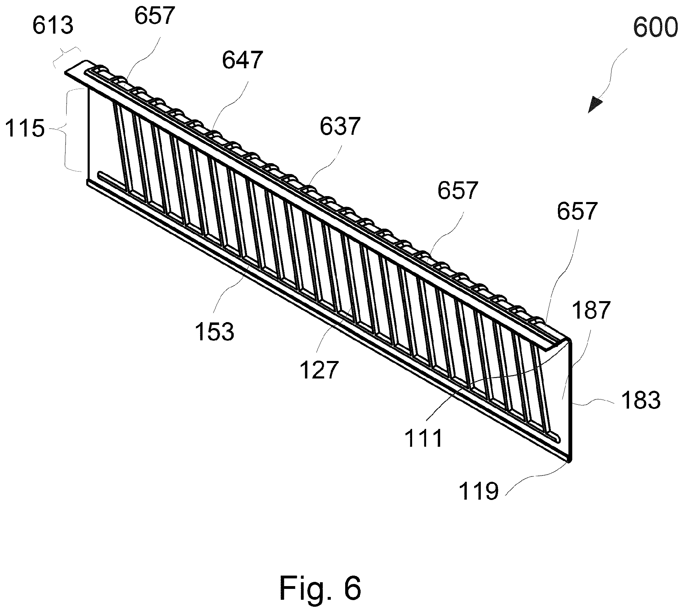

In some embodiments, the second portion 113 comprises the at least a condensation channel 137 and auxiliary channel 147a, 147b; however the embodiments are not limited thereto. In alternative embodiments, the second portion may further comprise additional second portion features. Fig. 6 is schematic perspective first view of an alternative heat exchanger, according to an example embodiment. Referring to Fig. 6, and referring to Figs. 1A to 5B, the second portion 613 further comprises at least an auxiliary through hole 657. The at least an auxiliary through hole 657 is positioned within the second portion 613, while not interfering with the at least a condensation channel 637 and the at least an auxiliary channel 647 (647a, 647b). The at least an auxiliary through hole 657 allows air to pass through portions of the second portion 613, facilitating heat dissipation and thermal performance of each heat exchanger fin 600; especially, when positioned horizontally and the plurality of fins face upward, allowing higher temperature air to more conveniently rise. In some embodiments, the amount of the at least an auxiliary through hole 657 is one; however the embodiments are not limited thereto. In alternative embodiments, the amount of the at least an auxiliary through hole 657 is two or more. In further alternative embodiments, the amount of the at least an auxiliary through hole 657 is twenty four, and positioned between and/or next to the at least an auxiliary channel 647 (647a, 647b). In some embodiments, the shape of the at least an auxiliary through hole 657 is circular-shaped; however, the embodiments are not limited thereto. In alternative embodiments, the shape is quadrilateral-shaped, hexagonal-shaped, or any other suitable shape known by those having ordinary skill in the relevant art. As long as air is allowed to pass through portions of the second portion 613, facilitating heat dissipation and thermal performance of each heat exchanger fin 600.

In some embodiments, each alternative heat exchanger fin 600, further comprising the at least an auxiliary through hole 657, may be employed in the heat exchanger 500 of Figs. 1A to 1B. The heat exchanger 500 comprises a plurality of alternative heat exchanger fins and a base plate 190 to cool at least one of an electric and/or electronic element, device and/or system. The heat exchanger 500 is as described in the embodiments, and for sake of brevity, will not be repeated hereafter.

In some embodiments, like features of each alternative heat exchanger fin 600, further comprising the at least an auxiliary through hole 657, is as described in the embodiments of each heat exchanger fin 100 of Figs. 2A to 3B, and for sake of brevity, will not be repeated hereafter.

In some embodiments, the method 400 of manufacturing each heat exchanger fin 100, under vacuum, having a working fluid therein, of Figs. 4 to 5B, may be employed to manufacture each heat exchange fin 600, further comprising the at least an auxiliary through hole 657. The method 400 employed to manufacture each heat exchange fin 600, further comprising the at least an auxiliary through hole 65 is as described in the embodiments, and for sake of brevity, will not be repeated hereafter.

In some embodiments, the at least a first metal sheet 183 and at least a second metal sheet 187 are made of aluminum, or an aluminum-alloy or the like, and formed by roll-bonding; however, the embodiments are not limited thereto. Those of ordinary skill in the relevant art may readily appreciate that other manufacturing processes may be employed to form the at least a first metal sheet 183 and at least a second metal sheet 187, such as stamping, depending upon material and manufacturing requirements. Those of ordinary skill in the relevant art may also readily appreciate that the at least a first metal sheet 183 and at least a second metal sheet 187 may be made of copper, or a copper-alloy or the like, or other malleable metal heat conducting material having a relatively high thermal conductivity depending upon application and design requirements. As long as each heat exchanger fin 100 may be formed by roll-bonding or stamping, or the like.

In some embodiments, the base plate 190 is made of aluminum, or an aluminum-alloy or the like and suitable for utilizing a brazing technique for thermal and mechanical, permanent brazing of each fin base 119 of each heat exchanger fin 100 to each mounting groove 192; however, the embodiments are not limited thereto. The base plate 190 may also be made of copper, or a copper-alloy or the like, or other malleable metal heat conducting material having a relatively high thermal conductivity depending upon application and design requirements. As long as each fin base 119 may be thermally and mechanically, permanently mounted to each mounting groove 192.

In some embodiments, the base plate 190 is made of a solid malleable metal heat conducting material having a relatively high thermal conductivity; however, the embodiments are not limited thereto. In alternative embodiments, the base plate 190 is under vacuum, and has a working fluid therein. In yet further alternative embodiments, the base plate 190 has an inlet and an outlet, having working fluid flowing therein and thereabout.

In some embodiments, if a stamping process or the like is used to form each heat exchanger fin 100 any bonding method known by those skilled in the relevant art, such as ultrasonic welding, diffusion welding, laser welding and the like, can be employed to bond and integrally form the first and second inner surfaces together at areas other than the formed areas of the at least a condensation channel 137, at least an auxiliary channel 147a, 147b, at least a connecting channel 127a, 127b, and at least an evaporation channel 153. As long as a vacuum seal can be achieved.

In some embodiments, if a stamping process or the like is employed, depending upon dimensions and application, axial or circumferential wick structures, having triangular, rectangular, trapezoidal, reentrant, etc. cross-sectional geometries, may be formed on inner surfaces of the at least a condensation channel 137, at least an auxiliary channel 147a, 147b, at least a connecting channel 127a, 127b, and at least an evaporation channel 153. The wick structure may be used to facilitate the flow of condensed fluid by capillary force back to the evaporation surface, keeping the evaporation surface wet for large heat fluxes.

Those of ordinary skill in the relevant art may readily appreciate that in alternative embodiments, further heat treatment processes can be employed throughout the manufacturing method of each heat exchanger fin 100, and the embodiments are not limited to those described. Additionally, those skilled in the relevant art may readily appreciate that additional steps can be added to the process in order to incorporate additional features into the finished product. Also, the steps can be altered depending upon different requirements. As examples, and not to be limiting: preparatory steps of alloying, casting, scalping and pre-heating: intermediate steps such as intermediate annealing; and finishing steps such as solution heat treatment or final annealing, stretching, leveling, slitting, edge trimming and aging, and the like may be employed.

In some embodiments, each heat exchanger fin 100 comprises two one sided inflated roll-bonded sheets having the at least a condensation channel 137 and at least an auxiliary channel 147a, 147b of the second portion 113 and at least a connecting channel 127a, 127b and at least an evaporation channel 153 of the first portion 115; however, the embodiments are not limited thereto. In alternative embodiments, each heat exchanger fin may comprise the at least a condensation channel, at least an auxiliary channel, at least a connecting channel, and at least an evaporation channel via a one sided inflated roll-bonded sheet. In yet further alternative embodiments, each heat exchanger fin having the at least a condensation channel 137 and at least an auxiliary channel 147a, 147b of the second portion 113 and at least a connecting channel 127a, 127b and at least an evaporation channel 153 of the first portion 115, may be employed as a stand-alone heat exchanger, and the embodiments are not limited thereto.

In some embodiments, the working fluid is made of acetone; however, the embodiments are not limited thereto. Other working fluids can be employed, as can be common for those skilled in the relevant art. As a non-limiting example, the working fluid can comprise cyclopentane or n-hexane. As long as the working fluid can be vaporized by a heat source and the vapor can condense back to the working fluid and flow back to the heat source.

A heat exchanger 500 comprising a plurality of heat exchanger fins 1000 and a base plate 190 is provided. Each heat exchanger fin 100 of the plurality of heat exchanger fins 1000 comprises an at least a second portion 113 having at least a condensation channel 137 and at least an auxiliary channel 147a, 147b and a first portion 115 having at least an evaporation channel 153 and at least a connecting channel 127a, 127b, communicating with the at least an auxiliary channel 147a, 147b, respectively. The second portion 113 and first portion 115 are formed by at least a first metal sheet 183 and at least a second metal sheet 187. The at least a condensation channel 137, at least an auxiliary channel 147a, 147b, at least a connecting channel 127a, 127b, and at least an evaporation channel 153 are under vacuum and have a working fluid therein. The at least a condensation channel 137, at least an auxiliary channel 147a, 147b, at least a connecting channel 127a, 127b, and at least an evaporation channel 153, increases the heat dissipation and thermal performance of each of the plurality of heat exchanger fins 1000. When operating vertically, the at least a second portion 113 increases the surface area of a heat source in thermal contact with the heat exchanger 500 while not increasing the square area allotted for the heat exchanger 500. Thus, the rate of convective heat transfer is even further increased while preventing insulating blanket layers around heat source walls from forming and restricting heat transfer.

In the embodiments, a plurality of heat exchanger fins, under vacuum, having a working fluid therein, each comprising at least a first metal sheet and at least a second metal sheet are provided. The at least a first and second metal sheet form a fin base, a fin intermediary and a fin tip, and a first portion, and a second portion. The second portion comprises at least a condensation channel, and at least an auxiliary channel. The first portion comprises at least an evaporation channel, and at least a connecting channel. Each heat exchanger fin, under vacuum, has a working fluid in the at least a condensation channel, at least an auxiliary channel, at least a connecting channel, and at least an evaporation channel, increasing heat dissipation and thermal performance thereof when compared to solid heat exchanger fins. Also, for electric and/or electronic elements, devices and systems that operate vertically, the at least a second portion increases the surface area of the heat source in thermal contact with the heat exchanger while not increasing the square area allotted for the heat exchanger. Thus, the rate of convective heat transfer is even further increased while preventing insulating blanket layers around heat source walls from forming and restricting heat transfer.

The presently disclosed inventive concepts are not intended to be limited to the embodiments shown herein, but are to be accorded their full scope consistent with the principles underlying the disclosed concepts herein. Directions and references to an element, such as "up," "down,", "upper," "lower," "horizontal," "vertical," "left," "right," and the like, do not imply absolute relationships, positions, and/or orientations. Terms of an element, such as "first" and "second" are not literal, but, distinguishing terms. As used herein, terms "comprises" or "comprising" encompass the notions of "including" and "having" and specify the presence of elements, operations, and/or groups or combinations thereof and do not imply preclusion of the presence or addition of one or more other elements, operations and/or groups or combinations thereof. Sequence of operations do not imply absoluteness unless specifically so stated. Reference to an element in the singular, such as by use of the article "a" or "an", is not intended to mean "one and only one" unless specifically so stated, but rather "one or more". As used herein, "and/or" means "and" or "or", as well as "and" and "or." As used herein, ranges and subranges mean all ranges including whole and/or fractional values therein and language which defines or modifies ranges and subranges, such as "at least," "greater than," "less than," "no more than," and the like, mean subranges and/or an upper or lower limit. All structural and functional equivalents to the elements of the various embodiments described throughout the disclosure that are known or later come to be known to those of ordinary skill in the relevant art are intended to be encompassed by the features described and claimed herein. Moreover, nothing disclosed herein is intended to be dedicated to the public regardless of whether such disclosure may ultimately explicitly be recited in the claims.

## Claims

1. A heat exchanger (500) comprising:
• a base plate (190) having a mounting surface (191) and a contact surface (199), opposite the mounting surface (191);
• a plurality of heat exchanger fins (1000), each heat exchanger fin comprising:
∘ a first portion (115) and a second portion (113; 613);
∘ a channel system divided into a first part within the first portion (115) and a second part within the second portion (113; 613);
∘ wherein the first portion (115) and the second portion (113; 613) are angled towards each other within an angle range of greater than 0° to less than 180°;
∘ wherein the channel system is under vacuum and contains a working fluid;
∘ wherein the channel system includes an evaporator region in the first portion (115), a condenser region in the second portion (113; 613), and a vapor flow region extending through both the first portion (115) and the second portion (113; 613) to connect the evaporator region and the condenser region;
• **characterized in that** the base plate (190) comprises a plurality of mounting grooves (192) corresponding to the dimensions of the fin bases (119) of the heat exchanger fins (100; 600);
• the heat exchanger fins (100) comprise a first metal sheet (183) and a second metal sheet (187) having a first inner surface assembled to a second inner surface, wherein the first metal sheet (183) and the second metal sheet (187) form the fin base (119) and wherein each fin base (119) of the plurality of heat exchanger fins (1000) is thermally and mechanically attached to the mounting surface (191) of the base plate (190).

2. The heat exchanger (500) of claim 1, wherein the plurality of mounting grooves (192) extend substantially parallel and are evenly spaced from each other.

3. The heat exchanger (500) of claim 1 or 2, wherein each fin base (119) of the plurality of heat exchanger fins (1000) is hemmed to reinforce strength and to increase surface area for conductive heat transfer from the base plate (190) to the respective heat exchanger fin (100).

4. The heat exchanger of any of claims 1 to 3, wherein the angle range between the first portion (115) and the second portion (113; 613) of each heat exchanger fin (100; 600) is between 75° and 105°, preferably substantially limited to 90°.

5. The heat exchanger (500) of any one of claims 1 to 4, wherein the channel system of each heat exchanger fin (100; 600) is configured to produce a fully thermally driven flow of the working fluid in a closed loop configuration.

6. The heat exchanger of any one of claims 1 to 5, wherein the evaporator region of each heat exchanger fin (100; 600) comprises at least one evaporation channel (153), and the condenser region comprises at least one condensation channel (137).

7. The heat exchanger of claim 6, wherein the channel system further comprises at least one connecting channel (127a, 127b) communicating with the at least one evaporation channel (153) and at least one auxiliary channel (147a, 147b; 647a, 647b) communicating with the at least one connecting channel (127a, 127b).

8. The heat exchanger of claim 7, wherein the volume of the condenser region is at least equal to or greater than the volume of the evaporator region.

9. The heat exchanger of any one of claims 6 to 8, wherein the at least one connecting channel (127a, 127b) and/or the at least one auxiliary channel (147a, 147b; 647a, 647b) are disposed at a slight angle to the at least one evaporation channel (153) and/or the at least one condensation channel (137), respectively.

10. The heat exchanger of any one of claims 6 to 9, wherein the at least one evaporation channel (153) and the at least one condensation channel (137) are disposed substantially parallel to each other.

11. The heat exchanger of any one of claims 1 to 10, wherein the main axis (M1) of the first portion (115) and the main axis (M2) of the second portion (113; 613) of each heat exchanger fin (100; 600) are oriented substantially vertical, namely in a range of ±15°, preferably in a range of ±7.5°, to vertical when the heat exchanger (500) is in use.

12. The heat exchanger of any one of claims 6 to 11, wherein the at least one connecting channel (127a, 127b) and/or the at least one auxiliary channel (147a, 147b; 647a, 647b) extend upwardly inclined to enhance downward working fluid flow.

13. The heat exchanger of any one of claims 6 to 12, wherein the second portion (613) of each heat exchanger fin (600) comprises at least one auxiliary through hole (657) that does not interfere with the at least one condensation channel (637) and the at least one auxiliary channel (647a, 647b).

14. The heat exchanger of any one of claims 1 to 13, wherein the base plate (190) and the plurality of heat exchanger fins (100; 600) are substantially oriented vertically, namely in a range of ±15°, preferably in a range of ±7.5°, to vertical when the heat exchanger (500) is in use.

15. The heat exchanger of any one of claims 1 to 14, wherein the base plate (190) comprises a mounting surface (191) and a contact surface (199), opposite the mounting surface (191), wherein the contact surface (199) is in contact with a first heat source (182) and a second heat source (188), and wherein the power requirement and maximum operating temperature allowance of the first heat source (182) is less than that of the second heat source (188).

16. The heat exchanger of claim 15, wherein, when in operation, the first heat source (182) is closer to ground (G) than the second heat source (188).

## Patentansprüche

1. Wärmetauscher (500) umfassend:
• eine Grundplatte (190) mit einer Montagefläche (191) und einer Kontaktfläche (199), die der Montagefläche (191) gegenüberliegt,
• eine Vielzahl von Wärmetauscherrippen (1000), wobei jede Wärmetauscherrippe umfasst:
∘ einen ersten Abschnitt (115) und einen zweiten Abschnitt (113; 613);
∘ ein Kanalsystem, das in einen ersten Teil innerhalb des ersten Abschnitts (115) und einen zweiten Teil innerhalb des zweiten Abschnitts (113; 613) unterteilt ist;
o wobei der erste Abschnitt (115) und der zweite Abschnitt (113; 613) innerhalb eines Winkelbereichs von mehr als 0° bis weniger als 180° gegeneinander abgewinkelt sind;
o wobei das Kanalsystem unter Vakuum steht und ein Arbeitsfluid enthält;
o wobei das Kanalsystem einen Verdampferbereich im ersten Abschnitt (115), einen Kondensatorbereich im zweiten Abschnitt (113; 613) und einen Dampfstrombereich umfasst, der sich sowohl durch den ersten Abschnitt (115) als auch durch den zweiten Abschnitt (113; 613) erstreckt, um den Verdampferbereich und den Kondensatorbereich zu verbinden;
• **dadurch gekennzeichnet, dass** die Grundplatte (190) eine Vielzahl von Befestigungsnuten (192) aufweist, die den Abmessungen der Rippenbasen (119) der Wärmetauscherrippen (100; 600) entsprechen;
• die Wärmetauscherrippen (100) umfassen ein erstes Metallblech (183) und ein zweites Metallblech (187) mit einer ersten Innenfläche, die mit einer zweiten Innenfläche verbunden ist, wobei das erste Metallblech (183) und das zweite Metallblech (187) die Rippenbasis (119) bilden und wobei jede Rippenbasis (119) der mehreren Wärmetauscherrippen (1000) thermisch und mechanisch an der Montagefläche (191) der Grundplatte (190) befestigt ist.

2. Wärmetauscher (500) nach Anspruch 1, wobei sich die mehreren Befestigungsnuten (192) im Wesentlichen parallel erstrecken und in gleichmäßigen Abständen voneinander angeordnet sind.

3. Wärmetauscher (500) nach Anspruch 1 oder 2, wobei jede Rippenbasis (119) der mehreren Wärmetauscherrippen (1000) umgebördelt ist, um die Festigkeit zu verstärken und die Oberfläche für die konduktive Wärmeübertragung von der Grundplatte (190) zu der jeweiligen Wärmetauscherrippe (100) zu vergrößern.

4. Wärmetauscher nach einem der Ansprüche 1 bis 3, wobei der Winkelbereich zwischen dem ersten Abschnitt (115) und dem zweiten Abschnitt (113; 613) jeder Wärmetauscherrippe (100; 600) zwischen 75° und 105° liegt, vorzugsweise im Wesentlichen auf 90° begrenzt ist.

5. Wärmetauscher (500) nach einem der Ansprüche 1 bis 4, wobei das Kanalsystem jeder Wärmetauscherrippe (100; 600) ausgebildet ist, um eine vollständig thermisch angetriebene Durchströmung des Arbeitsfluids in einem geschlossenen Kreislauf zu erzeugen.

6. Wärmetauscher nach einem der Ansprüche 1 bis 5, wobei der Verdampferbereich jeder Wärmetauscherrippe (100; 600) mindestens einen Verdampfungskanal (153) umfasst und der Kondensatorbereich mindestens einen Kondensationskanal (137) umfasst.

7. Wärmetauscher nach Anspruch 6, wobei das Kanalsystem ferner mindestens einen Verbindungskanal (127a, 127b), der mit dem mindestens einen Verdampfungskanal (153) in Verbindung steht, und mindestens einen Hilfskanal (147a, 147b; 647a, 647b), der mit dem mindestens einen Verbindungskanal (127a, 127b) in Verbindung steht, umfasst.

8. Wärmetauscher nach Anspruch 7, wobei das Volumen des Kondensatorbereichs mindestens gleich oder größer als das Volumen des Verdampferbereichs ist.

9. Wärmetauscher nach einem der Ansprüche 6 bis 8, wobei der mindestens eine Verbindungskanal (127a, 127b) und/oder der mindestens eine Hilfskanal (147a, 147b; 647a, 647b) in einem geringen Winkel zu dem mindestens einen Verdampfungskanal (153) bzw. dem mindestens einen Kondensationskanal (137) angeordnet sind.

10. Wärmetauscher nach einem der Ansprüche 6 bis 9, wobei der mindestens eine Verdampfungskanal (153) und der mindestens eine Kondensationskanal (137) im Wesentlichen parallel zueinander angeordnet sind.

11. Wärmetauscher nach einem der Ansprüche 1 bis 10, wobei die Hauptachse (M1) des ersten Abschnitts (115) und die Hauptachse (M2) des zweiten Abschnitts (113; 613) jeder Wärmetauscherrippe (100; 600) im Wesentlichen vertikal, nämlich in einem Bereich von ±15°, vorzugsweise in einem Bereich von ±7,5°, zur Vertikalen ausgerichtet sind, wenn der Wärmetauscher (500) in Betrieb ist.

12. Wärmetauscher nach einem der Ansprüche 6 bis 11, wobei der mindestens eine Verbindungskanal (127a, 127b) und/oder der mindestens eine Hilfskanal (147a, 147b; 647a, 647b) nach oben geneigt verlaufen, um die Abwärtsströmung des Arbeitsfluids zu verbessern.

13. Wärmetauscher nach einem der Ansprüche 6 bis 12, wobei der zweite Abschnitt (613) jeder Wärmetauscherrippe (600) mindestens ein Hilfsdurchgangsloch (657) aufweist, das den mindestens einen Kondensationskanal (637) und den mindestens einen Hilfskanal (647a, 647b) nicht beeinträchtigt.

14. Wärmetauscher nach einem der Ansprüche 1 bis 13, wobei die Grundplatte (190) und die mehrere Wärmetauscherrippen (100; 600) im Wesentlichen vertikal ausgerichtet sind, nämlich in einem Bereich von ±15°, vorzugsweise in einem Bereich von ±7,5°, zur Vertikalen, wenn der Wärmetauscher (500) in Betrieb ist.

15. Wärmetauscher nach einem der Ansprüche 1 bis 14, wobei die Grundplatte (190) eine Montagefläche (191) und eine der Montagefläche (191) gegenüberliegende Kontaktfläche (199) umfasst, wobei die Kontaktfläche (199) mit einer ersten Wärmequelle (182) und einer zweiten Wärmequelle (188) in Kontakt steht und wobei der Energiebedarf und die maximale Betriebstemperaturabweichung der ersten Wärmequelle (182) geringer sind als die der zweiten Wärmequelle (188).

16. Wärmetauscher nach Anspruch 15, wobei die erste Wärmequelle (182) im Betrieb näher am Boden (G) angeordnet ist als die zweite Wärmequelle (188).

## Revendications

1. Échangeur de chaleur (500) comprenant :
• une plaque de base (190) ayant une surface de montage (191) et une surface de contact (199), opposée à la surface de montage (191) ;
• une pluralité d'ailettes d'échangeur de chaleur (1000), chaque ailette d'échangeur de chaleur comprenant :
o une première portion (115) et une seconde portion (113 ; 613) ;
o un système de canaux divisé en une première partie dans la première portion (115) et une seconde partie dans la seconde portion (113 ; 613) ;
∘ dans lequel la première portion (115) et la seconde portion (113 ; 613) sont inclinées l'une vers l'autre dans une plage d'angles comprise strictement entre 0° et 180° ;
o dans lequel le système de canaux est sous vide et contient un fluide de travail ;
o dans lequel le système de canaux comprend une région d'évaporateur dans la première portion (115), une région de condenseur dans la seconde portion (113 ; 613) et une région d'écoulement de vapeur s'étendant à travers à la fois la première portion (115) et la seconde portion (113 ; 613) pour relier la région d'évaporateur et la région de condenseur ;
• **caractérisé en ce que** la plaque de base (190) comprend une pluralité de rainures de montage (192) correspondant aux dimensions des bases d'ailettes (119) des ailettes d'échangeur de chaleur (100 ; 600) ;
• les ailettes d'échangeur de chaleur (100) comprennent une première feuille métallique (183) et une seconde feuille métallique (187) ayant une première surface intérieure assemblée à une seconde surface intérieure, dans lequel la première feuille métallique (183) et la seconde feuille métallique (187) forment la base d'ailette (119) et dans lequel chaque base d'ailette (119) de la pluralité d'ailettes d'échangeur de chaleur (1000) est fixée thermiquement et mécaniquement à la surface de montage (191) de la plaque de base (190).

2. Échangeur de chaleur (500) selon la revendication 1, dans lequel la pluralité de rainures de montage (192) s'étendent de manière sensiblement parallèle et sont espacées de manière régulière les unes des autres.

3. Échangeur de chaleur (500) selon la revendication 1 ou 2, dans lequel chaque base d'ailette (119) de la pluralité d'ailettes d'échangeur de chaleur (1000) est ourlée pour renforcer la résistance et augmenter la superficie de transfert de chaleur par conduction de la plaque de base (190) vers l'ailette d'échangeur de chaleur respective (100).

4. Échangeur de chaleur selon l'une des revendications 1 à 3, dans lequel la plage d'angles entre la première portion (115) et la seconde portion (113 ; 613) de chaque ailette d'échangeur de chaleur (100 ; 600) est compris entre 75° et 105°, de préférence sensiblement limité à 90°.

5. Échangeur de chaleur (500) selon l'une quelconque des revendications 1 à 4, dans lequel le système de canaux de chaque ailette d'échangeur de chaleur (100 ; 600) est configuré pour produire un écoulement entièrement entraîné thermiquement du fluide de travail dans une configuration en boucle fermée.

6. Échangeur de chaleur selon l'une quelconque des revendications 1 à 5, dans lequel la région d'évaporateur de chaque ailette d'échangeur de chaleur (100 ; 600) comprend au moins un canal d'évaporation (153), et la région de condenseur comprend au moins un canal de condensation (137).

7. Échangeur de chaleur selon la revendication 6, dans lequel le système de canaux comprend en outre au moins un canal de raccordement (127a, 127b) communiquant avec l'au moins un canal d'évaporation (153) et au moins un canal auxiliaire (147a, 147b ; 647a, 647b) communiquant avec l'au moins un canal de raccordement (127a, 127b).

8. Échangeur de chaleur selon la revendication 7, dans lequel le volume de la région de condenseur est au moins supérieur ou égal au volume de la région d'évaporateur.

9. Échangeur de chaleur selon l'une quelconque des revendications 6 à 8, dans lequel l'au moins un canal de raccordement (127a, 127b) et/ou l'au moins un canal auxiliaire (147a, 147b ; 647a, 647b) sont disposés selon un léger angle par rapport à l'au moins un canal d'évaporation (153) et/ou l'au moins un canal de condensation (137), respectivement.

10. Échangeur de chaleur selon l'une quelconque des revendications 6 à 9, dans lequel l'au moins un canal d'évaporation (153) et l'au moins un canal de condensation (137) sont disposés de manière sensiblement parallèle l'un à l'autre.

11. Échangeur de chaleur selon l'une quelconque des revendications 1 à 10, dans lequel l'axe principal (M1) de la première portion (115) et l'axe principal (M2) de la seconde portion (113 ; 613) de chaque ailette d'échangeur de chaleur (100 ; 600) sont orientés sensiblement verticalement, à savoir dans une plage de ±15°, de préférence dans une plage de ±7,5°, par rapport à la verticale lorsque l'échangeur de chaleur (500) est en utilisation.

12. Échangeur de chaleur selon l'une quelconque des revendications 6 à 11, dans lequel l'au moins un canal de raccordement (127a, 127b) et/ou l'au moins un canal auxiliaire (147a, 147b ; 647a, 647b) s'étendent vers le haut en étant inclinés afin d'améliorer l'écoulement vers le bas du fluide de travail.

13. Échangeur de chaleur selon l'une quelconque des revendications 6 à 12, dans lequel la seconde portion (613) de chaque ailette d'échangeur de chaleur (600) comprend au moins un trou traversant auxiliaire (657) qui n'interfère pas avec l'au moins un canal de condensation (637) et l'au moins un canal auxiliaire (647a, 647b).

14. Échangeur de chaleur selon l'une quelconque des revendications 1 à 13, dans lequel la plaque de base (190) et la pluralité d'ailettes d'échangeur de chaleur (100 ; 600) sont orientées sensiblement verticalement, à savoir dans une plage de ±15°, de préférence dans une plage de ±7,5°, par rapport à la verticale lorsque l'échangeur de chaleur (500) est en utilisation.

15. Échangeur de chaleur selon l'une quelconque des revendications 1 à 14, dans lequel la plaque de base (190) comprend une surface de montage (191) et une surface de contact (199), opposée à la surface de montage (191), dans lequel la surface de contact (199) est en contact avec une première source de chaleur (182) et une seconde source de chaleur (188), et dans lequel la puissance requise et la température de fonctionnement maximale admissible de la première source de chaleur (182) sont inférieures à celles de la seconde source de chaleur (188).

16. Échangeur de chaleur selon la revendication 15, dans lequel, en fonctionnement, la première source de chaleur (182) est plus proche du sol (G) que la seconde source de chaleur (188).
